# EUROPEAN PATENT SPECIFICATION

(11) **EP 0 303 435 B1**
(45) Date of publication and mention of the grant of the patent: **02.11.1994**
(21) Application number: 88307335.5
(22) Date of filing: 08.08.1988
(51) Int. Cl.: H01L 29/52, H01L 29/60

(54) **Bipolar transistors**
Bipolartransistoren
Transistors bipolaires

(30) Priority: 11.08.1987 JP 199006/87
(43) Date of publication of application: 15.02.1989
(73) Proprietor: SONY CORPORATION, Tokyo 141 (JP)
(72) Inventor: Miwa, Hiroyuki c/o Patents Division, Shinagawa-ku Tokyo 141 (JP)
(74) Representative: Cotter, Ivan John

(56) References cited:
- EP-A- 0 144 444
- EP-A- 0 177 246
- FR-A- 2 352 403
- US-A- 3 534 234
- US-A- 4 252 581
- IBM TECHNICAL DISCLOSURE BULLETIN, vol. 24, no. 9, February 1982, pages 4662-4664, New York, US; H.H. HANSEN et al.: "Ultra dense, high performance bipolartransistor"
- PATENT ABSTRACTS OF JAPAN, vol. 10, no. 65 (E-388), 14 March 1986 ; & JP-A-60214563

## Description

This invention relates to bipolar transistors.

It has previously been proposed to employ a structure, for a bipolar transistor that is to operate at an extremely high speed, in which base contact and collector contact are achieved by arranging for a base contact electrode and a collector contact electrode to extend into a device forming region from an end of a region delimited or surrounded by an isolation region.

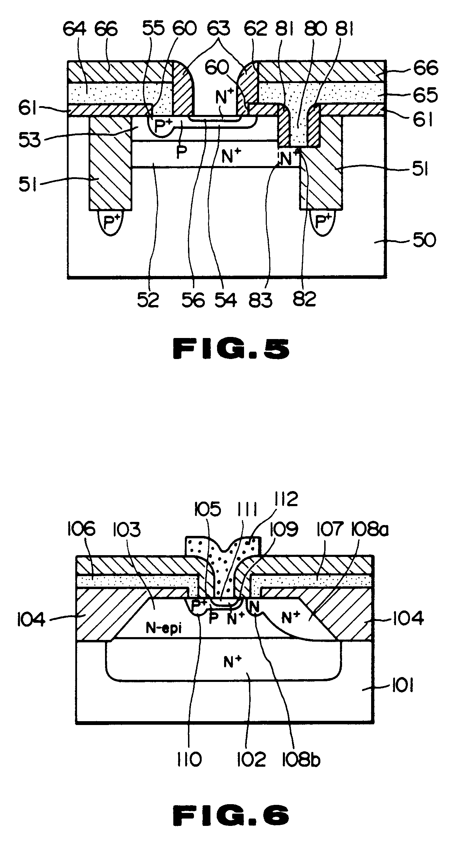

Figure 6 of the accompanying drawings shows in cross-section such a bipolar transistor in which the base contact electrode is arranged in symmetry with the collector contact electrode. An N⁺ type buried collector region 102 is formed on a semiconductor substrate 101 and an N type epitaxial layer 103 is formed on the collector region 102. An isolation region 104 is formed so as to surround the layer 103. The N type epitaxial layer 103 serves as a device forming region. An N⁺ type collector contact region 108a and an N type collector contact region 108b for electrical connection with the buried collector region 102, a P type intrinsic base region 109, a graft base region 110 and an emitter region 111 are formed within the N type epitaxial layer 103. A base contact electrode 106 and a collector contact electrode 107, covered by an insulating layer, are formed in an opening region 105 on the surface of the N type epitaxial layer 103 in symmetry with each other. A thin polycrystalline silicon layer 112 is formed on the insulating layer covering the contact electrodes 106 and 107.

The collector of the above-described bipolar transistor is connected by way of the buried collector region 102, the N⁺ type collector contact region 108a and the N type collector contact region 108b to the collector contact electrode 107, while the base of the transistor is connected by way of the intrinsic base region 109 and the graft base region 110 to the base contact electrode 106.

In the above-described bipolar transistor, the following problems are encountered in connection with the transistor characteristics.

With reduction or shrinking of the dimensions of the device components, the spacing or interval between the intrinsic base region 109 and the N type collector region 108b is reduced. In such a case, the P type intrinsic base region 109 and the N type collector contact region 108b can collide with each other, thus resulting in a reduced collector to base breakdown voltage and an increased parasitic capacitance.

On the other hand, it is desirable to increase the impurity concentration of the N type collector contact region 108b in order to lower the resistance of the region 108b. However, it is of necessity not possible to lower the collector resistance since the impurity regions again may collide with each other if the impurity concentration is increased.

European patent application EP-A-0,144,444 describes an example of a method for manufacturing a bipolar transistor. IBM Technical Disclosure Bulletin, volume 24, No. 9, February 1982, pages 4662 - 4664 describes an example of bipolar transistor fabrication using trench isolation. United States patent US-A-3,534,234 describes the formation of isolation regions by selective oxidation and the provision of openings through an isolation region. French patent application FR-A-2,352,403 also describes the creation of a semiconductor device using trench isolation. The abstract of JP-A-60214563 in Patent Abstracts of Japan, vol 10, No 65 (E-388) describes a transistor where polycrystalline layers, each having an As-Doped aperture part and n + type emitter and collector layers formed by heat treatment. A bipolar transistor according to the preamble of claim 1 is described in US-A-4252581.

In accordance with a first aspect of the invention, there is provided a bipolar transistor comprising: a monocrystalline semiconductor body on a surface of which an isolation region is formed; a device forming region surrounded by the isolation region; a buried collector region formed in a portion of the device forming region within the semiconductor body; a base region adjacent a portion of a surface of the device forming region; an emitter region adjacent a portion of the surface of the device forming region and surrounded by the base region; a base contact electrode extending from the isolation region to above the device forming region and connected to the base region on the surface of the device forming region; a collector contact electrode spaced from the base contact electrode; and an opening formed through at least a portion of the isolation region; the collector contact electrode being formed over the isolation region and extending through the opening, characterised by: the collector contact electrode being formed from a semiconductor layer which extends over the isolation region and also extends through the opening; a collector contact region contiguous with the buried collector region formed by impurity diffusion from the collector contact electrode for interconnecting the collector contact electrode and the buried collector region; the emitter region being isolated from the base contact electrode and the collector contact electrode by a side wall insulating layer; and said base region comprising an intrinsic base region formed by diffusion from a silicon layer within the side wall.

In accordance with a second aspect of the invention, there is provided a process for manufacturing a bipolar transistor including a buried collector region in a device forming region surrounded by an isolation region of a monocrystalline semiconductor body; and a base region and an emitter region surrounded by the base region on a surface of the device forming region; the process comprising: forming an opening through the isolation by etching off at least a portion of the isolation region; forming a semiconductor layer on the entire surface which extends over the isolation region and extends into the opening; partially removing the semiconductor layer to form a collector contact electrode spaced from a base contact electrode, the collector contact electrode extending through the opening; and forming a collector contact region contiguous to the buried collector region by impurity diffusion from the collector contact electrode, the collector contact region interconnecting the buried collector region and the collector contact electrode; forming a side wall insulating layer where the semiconductor layer was removed; and forming an intrinsic base region by diffusion from a silicon layer between the side walls.

Preferably, the process additionally comprises: forming the buried collector region in a monocrystalline semiconductor substrate; producing an epitaxial layer on the monocrystalline semiconductor substrate; forming a mask selectively on the epitaxial layer, which layer acts as the device forming region, and also forming the isolation region surrounding the device forming region by selective oxidation; forming an insulating film over the entire surface; forming the opening in a portion of the device forming region; forming the semiconductor layer on the entire surface which extends over the isolation region and extends into the opening; introducing an impurity into the semiconductor layer so that the layer has different conductivity types as between a first region thereof and a second region thereof which is spaced from the first region and extends through the opening; partially removing the semiconductor layer so that it is divided to form the base and collector contact electrodes corresponding to the first and second regions of different conductivity types and so that the device forming region is exposed; forming the side wall insulating layer where the semiconductor layer was removed; and forming an emitter region contiguous with a surface of the side wall insulating layer.

In an embodiment of the invention, a bipolar transistor has a buried collector region, a base region and an emitter region in a device forming region delimited or surrounded by an isolation region. The emitter region is isolated by a side wall insulating layer on a major substrate surface. The base region is connected to the base contact electrode by way of a graft base region. The buried collector region is connected to a collector contact electrode separated from the base contact electrode. The collector contact electrode is connected to the buried collector region by way of an opening formed at at least a portion of the isolation region. In a manner distinct from an opening formed previously by selective oxidation, the opening is formed through an isolation region after formation of the isolation region. By making a connection by way of this opening, a larger distance is provided between the base region and the collector contact region to avoid collision between the impurity regions.

In the process for making the bipolar transistor there are steps of forming a buried collector region, a base region and an emitter region in a device forming region surrounded by an isolation region, forming an impurity region contiguous to the buried collector region through an opening formed by etching away at least a portion of the isolation region, and forming a collector contact electrode in said opening.

Preferred embodiments of the invention described below provide: a bipolar transistor wherein collision between the base region and the collector contact region may be effectively avoided to enable reduction or shrinking of the dimensions of the device to be achieved; and a process for preparing such a bipolar transistor with a higher efficiency. In the preferred bipolar transistors, a buried collector region, a base region and an emitter region are formed in a device forming region surrounded by an isolation region, an emitter region is formed by the intermediary of a semiconductor layer isolated by a side wall insulating layer, and a base contact electrode and a collector contact electrode are arranged in symmetry with each other.

The invention will now be further described, by way of illustrative and non-limiting example, with reference to the accompanying drawings, in which:
Figure 1 is a cross-sectional view of a bipolar transistor according to a first embodiment of the invention;
Figures 2a to 2e are cross-sectional views of the bipolar transistor at respective different stages during a step by step process for manufacturing it;
Figure 3 is a plan view of a second embodiment of the invention;
Figure 4 is a cross-sectional view taken along a line IV-IV in Figure 3;
Figure 5 is a cross-sectional view of a third embodiment of the invention; and
Figure 6 is a cross-sectional view of the above-described previously proposed bipolar transistor.

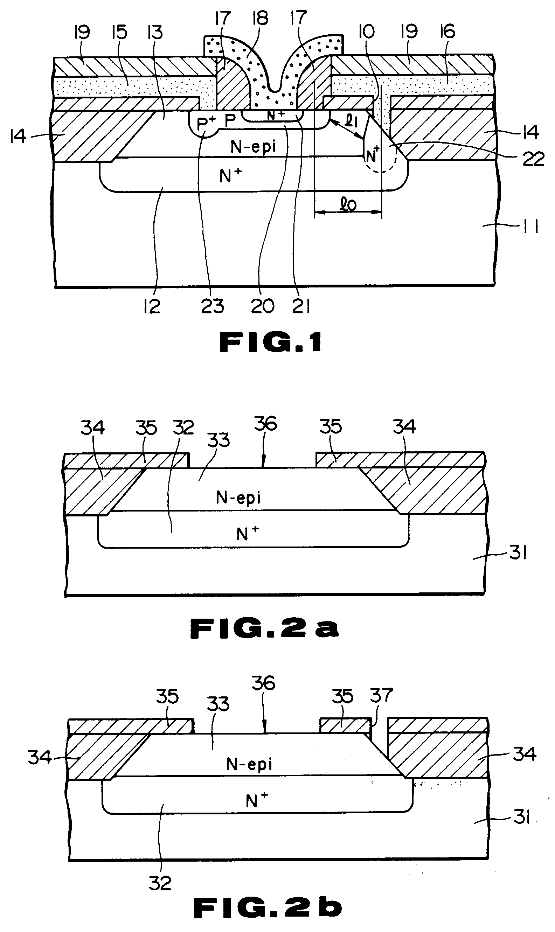

The bipolar transistor shown in Figure 1 comprises an N⁺ type buried collector region 12 which is formed on a semiconductor substrate 11. An N type epitaxial layer 13 is formed on the buried collector region 12. An isolation region 14 is formed adjacent to the N type epitaxial layer 13 by a selective oxidation process. The N type epitaxial layer 13 is a device forming region and is surrounded by the isolation region 14. A base contact electrode 15, covered by an insulating layer 19, is formed on the surface of the N type epitaxial layer 13, over the isolation region 14, so as partially to contact the surface of the layer 13. Similarly, a collector contact electrode 16 is provided in symmetry with the base contact electrode 15 with respect to an emitter region, and extends over the isolation region 14 and is covered by an insulating layer 19. The base contact electrode 15 has a terminal portion that contacts the N type epitaxial layer 13. In the region of contact between the terminal portion of the base contact region 15 and the N type epitaxial layer 13, a P⁺ type graft base region 23 is formed by diffusion of impurities from the base contact electrode 15. The graft base region 23 is contiguous with a P type intrinsic base region 20 formed on the major surface of the N type epitaxial layer 13. An N⁺ emitter region 21 is formed within the intrinsic base region 20 so as to face the major surface of the layer 13. The emitter region 21 is connected to an emitter electrode (not shown) through a thin polycrystalline silicon layer 18 applied to a space between side walls 17, 17 formed on end surfaces of the base contact electrode 15, collector contact electrode 16 and insulating layer 19.

The collector contact electrode 16 is not connected to the N type epitaxial layer 13 in the vicinity of the side walls 17, but is connected to the buried collector region 12 through an opening 10 formed in the isolation region 14 towards the side thereof where the collector contact electrode 16 is formed. It is to be noted that the buried collector region 12 and the collector contact electrode 16 are electrically connected to each other through an N⁺ type collector contact region 22 which is a high concentration impurity region formed in the N type epitaxial layer 13 between the buried collector region 12 and the opening 10 such that, as described later, the characteristics of the bipolar transistor may be improved.

The opening 10 is formed on a boundary surface which is inclined relative to the major surface and which is disposed between the isolation region 14 and the N type epitaxial layer 13. Although it is known to make an electrical contact or connection at a region previously isolated by the insulating region, the opening 10 is formed in the present embodiment through the isolation region 14. By providing the opening 10 in this manner, the opening 10 is shifted towards the isolation region 14 by a distance equal to l₀, for example, as compared to the case shown in Figure 6 in which the collector contact or connection is made in the vicinity of a position corresponding to the side wall 17, similarly to the base contact or connection. Hence, the distance l₁ between the intrinsic base region 20 and the collector contact region 22 may be selected to be larger by an amount corresponding to the thus-obtained distance l₀. This results in prevention of collision between the intrinsic base region 20 and the collector contact region 22 for reducing parasitic capacitance and elevating the collector to base breakdown voltage. Also, since the intrinsic base region 20 and the collector contact region 22 are formed with the relatively large distance l₁ between them, the impurity concentration of the collector contact region 22 may be increased in order to lower the collector resistance. This is favourable above all when reduction or shrinking of the dimensions of the device is aimed at.

It is unnecessary for the base contact electrode 15 and the collector contact electrode 16 to be arranged completely in symmetry with each other. Thus, the electrodes 15, 16 may be arranged so as partially to confront each other. The position of the opening 10 may be such that a sufficient distance may be obtained between it and the intrinsic base region 20, while the opening 10 may be extended through to the bottom surface of the isolation region 14. A PNP type transistor may naturally be employed as the bipolar transistor.

A process for manufacturing the bipolar transistor will now be described. It is possible, with the present process, effectively to avoid collision between the base region and the collector region to permit a bipolar transistor with improved device characteristics to be produced easily. The process will be described hereinbelow on a step by step basis with reference to Figures 2a to 2e.

First, as shown in Figure 2a, an N⁺ type buried collector region 32 is formed on a semiconductor substrate 31, and a N type epitaxial layer 33 is formed or provided on the layer 32. An isolation region 34 is formed selectively on the N type epitaxial layer 33, for example by selective oxidation. After formation of the isolation region 34, the region 34 is planarised and the entire surface of the region 34 is covered with a chemical vapour deposition (CVD) SiO₂ film or layer 35. The surface of the N type epitaxial layer 33, which represents a device forming region, is covered by the CVD SiO₂ film 35. Then, a portion of the CVD SiO₂ film 35 disposed on the N type epitaxial layer 33 is removed for exposing a portion 36 of the surface of the epitaxial layer.

Then, as shown in Figure 2b, an opening 37 is formed by etching away a portion of the isolation region 34. The opening 37 may be formed simultaneously with etching of the film 35 to form the exposed surface portion 36 or it may be formed by a separate etching process. The opening 37 may, for example, be positioned on the boundary surface between the insulation region 34 and the N type epitaxial layer 33, which is inclined relative to the major surface. The area of the buried collector region 32 can be reduced by making the collector contact at this position. However, this positioning is only illustrative and the collector contact may be made at any other position which will ensure a positive separation between the collector contact region and the intrinsic base region to be formed later. Thus, as an example of one alternative, the opening 37 may be formed so that the buried collector region 32 will exist directly at the bottom of the opening. As a further alternative, the impurity region contiguous to the buried collector region 32 may be formed on the bottom of the opening 37, such as by ion implantation, after the formation of the opening 37, with the exposed surface portion 36 being masked.

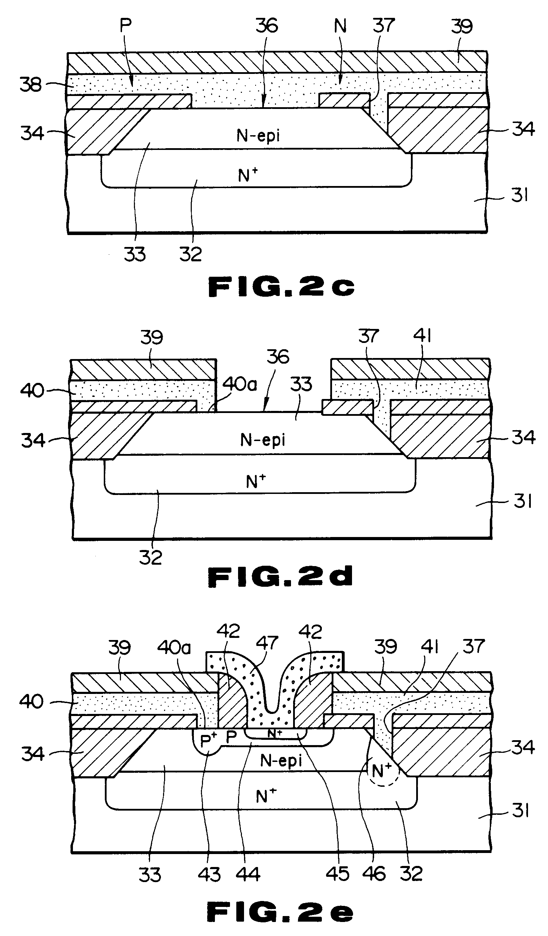

After formation of the opening 37, a polycrystalline silicon layer 38 is formed over the entire surface, as shown in Figure 2c. The opening 37 is filled with the polycrystalline silicon layer 38, the polycrystal silicon layer 38 then being contiguous with the N type epitaxial layer 33 at the exposed surface 36. The thus-formed polycrystalline silicon layer 38 may be planarised if necessary or if desired.

Then, using a resist mask, N type and P type impurities are selectively introduced by ion implantation into the polycrystalline silicon layer 38. Thus, an N type impurity for making collector contact is introduced into a part of the polycrystalline silicon layer 38 including the exposed surface portion 36 and the opening 37, and a P type impurity for making base contact is introduced into a part of the polycrystalline silicon layer 38 including the exposed surface portion 36 and not including the opening 37. After the impurities are selectively introduced in this manner, a CVD SiO₂ film 39 is deposited over the entire surface of the polycrystalline silicon layer 38.

Then, using a mask as required, an opening for an emitter is formed, as shown in Figure 2d. Thus, a collector contact electrode 41 composed of the part of the polycrystalline silicon layer 38 into which the N type impurity has been introduced is formed in symmetry with a base contact electrode 40 composed of the part of the polycrystalline silicon layer 38 into which the P type impurity has been introduced, with respect to an emitter region which will be formed in the next process step. Since the collector contact electrode 41 also fills the opening 37, collector contact may be made at the opening 37, so that the collector contact electrode need not be extended into contact with the N type epitaxial layer 33 at the exposed surface 36 of the N type epitaxial layer 33. The base contact electrode 40 makes contact at a terminal portion 40a thereof with the N type epitaxial layer 33, and the base contact region is formed by impurity diffusion from the terminal portion 40a.

Then, on that portion of the surface where the emitter opening is formed as described above, a CVD SiO₂ film is formed and then etched back to form side walls 42, 42. A thin polycrystalline silicon layer 47 is then formed between the side walls 42, 42 and a P type impurity is introduced into the layer 47.

Then, an annealing operation is carried out so that, as shown in Figure 2e, a P type base contact region 43 is formed by diffusion from the terminal portion 40a of the base contact electrode 40, while an intrinsic base region 44 is formed by diffusion from the thin polycrystalline silicon layer 47 into which the impurity has been introduced. Also, in the same step or in a separate step, an N⁺ type collector contact region 46 interconnecting the buried collector region 32 and the collector contact electrode 41 is formed by impurity diffusion from the collector contact electrode 41 within the opening 37.

The N type impurity is then introduced to a high concentration into the thin polycrystalline silicon layer 47 and annealing is then carried out so that an emitter region 45 is formed in self-alignment with the intrinsic base region 44.

It is to be noted that the side wall 42 may be of a dual structure, which is highly effective, above all when a projection such as an oxide film exists in the vicinity of the side wall of the collector contact electrode 41. Any type of annealing, such as rapid thermal annealing, may be employed.

In accordance with the above-described process for preparing or manufacturing the bipolar transistor, a larger distance may be provided between the intrinsic base region 44 and the collector contact region 46 for reducing the parasitic capacitance and improving the collector to base breakdown voltage. In addition, the device area may be reduced for promoting integration and reduction or shrinking of the dimensions of the bipolar transistor.

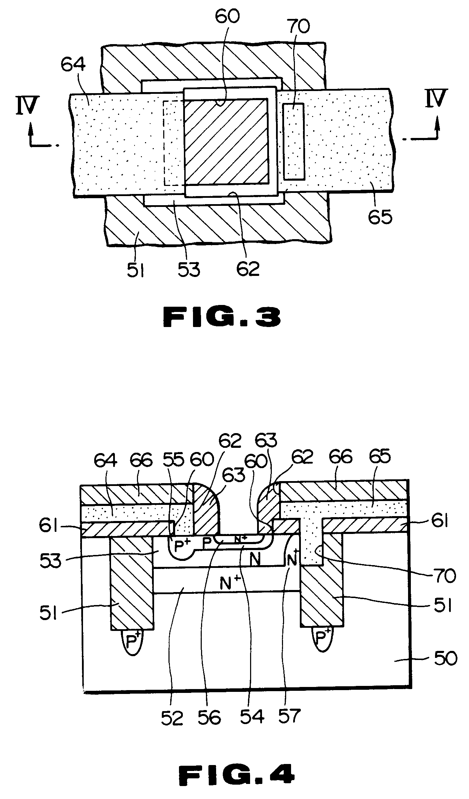

Figures 3 and 4 illustrate the construction of a bipolar transistor having a trench-shaped isolation region. The construction is such that an N⁺ type buried collector region 52 is formed on a semiconductor substrate 50 and an N type semiconductor crystal region 53 is formed on the N⁺ type buried collector region 52. The N type semiconductor crystal region 53 represents a device forming region which is surrounded by a trench-shaped isolation region 51.

A base contact electrode 64 is formed on the surface of the N type semiconductor crystal region 53 so as partially to contact said surface and to overlie an insulating layer 61. The base contact electrode 64 is covered by an insulating layer 66. A collector contact electrode 65 is formed on the insulating layer 61 in symmetry with the base contact electrode 64, and is covered by the insulating layer 66. The collector contact electrode 65 is not in surfacial contact with the semiconductor crystal region 53 and has an end surface 62 covered by a side wall 63. A portion of the collector contact electrode 65 fills an opening 70 formed in a portion of the trench-shaped isolation region 51. The collector contact electrode 65 is connected to an N⁺ type collector contact region 57 formed in the semiconductor crystal region 53 as a continuation of the N⁺ type buried collector region 52. A base contact region 55 is formed by diffusion on a portion of the semiconductor crystal region 53 contacted by the base contact electrode 64, with the electrode 64 acting as a surface of diffusion. An intrinsic base region 54 is formed by diffusion with the side wall 63 acting as a mask and is connected to the base contact region 55. An emitter region 56 is similarly formed at the inner side of the intrinsic base region 54, using the same mask.

In the above-described bipolar transistor, a larger distance may be obtained between the intrinsic base region 54 and the collector contact region 57, so that collision between the intrinsic base region 54 and the collector contact region 57 may be avoided so as to reduce the parasitic capacitance and improve the collector to base breakdown voltage. In addition, owing to the larger distance between the intrinsic base region 54 and the collector contact region 57, a higher impurity concentration of the collector contact region 57 may be realised with a lower collector resistance. A further advantage may be obtained when reduction or shrinking of the dimensions of the device components is aimed at.

Figure 5 illustrates a modification of the bipolar transistor shown in Figures 3 and 4. The same references are used in Figure 5 to designate parts or components which are the same as those shown in Figure 4 and the corresponding description will not be repeated.

The bipolar transistor shown in Figure 5 differs from that shown in Figure 4 as regards the structure of an opening 80 thereof. Thus, a side wall 81 formed of an insulating material is formed on the lateral wall of the opening 80, the inside of which is filled by a collector contact electrode 65. On a bottom 82 of the opening 80, a portion 83 of an N⁺ type buried collector region 52 is connected to the portion of the collector contact electrode 65 which is defined by the side wall 81. In this modified bipolar transistor, isolation between the collector contact region 65 and the intrinsic base region 54 can be additionally ensured by the side wall 81 of the opening 80.

It is to be noted that the base contact electrode and the collector contact electrode need not be arranged completely symmetrically with each other, and that the bipolar transistor may also be a PNP type transistor.

## Claims

1. A bipolar transistor comprising:
a monocrystalline semiconductor body (11, 31, 50) on a surface of which an isolation region (14, 34, 51) is formed;
a device forming region (13, 33, 53) surrounded by the isolation region (14, 34, 51);
a buried collector region (12, 32, 52, 52) formed in a portion of the device forming region (13, 33, 53) within the semiconductor body (11, 31, 50);
a base region (20/23, 44/43, 54/55) adjacent a portion of a surface of the device forming region (13, 33, 53);
an emitter region (21, 45, 56) adjacent a portion of the surface of the device forming region (13, 33, 53) and surrounded by the base region (20/23, 44/43, 54/55);
a base contact electrode (15, 40, 64) extending from the isolation region (14, 34, 51) to above the device forming region (13,33, 53) and connected to the base region (20/23, 44/43, 54/55) on the surface of the device forming region (13, 33, 53);
a collector contact electrode (16, 41, 65) spaced from the base contact electrode (15, 40, 64); and
an opening (10, 37, 70, 80) formed through at least a portion of the isolation region (14, 34, 51);
the collector contact electrode (16, 41, 65) being formed over the isolation region (14, 34, 51) and extending through the opening (10, 37, 70, 80), characterised by:
the collector contact electrode (16, 41, 65) being formed from a semiconductor layer (38) which extends over the isolation region (14, 34, 51) and also extends through the opening (10, 37, 70, 80);
a collector contact region (22, 46, 57, 83) contiguous with the buried collector region (12, 32, 52, 52) formed by impurity diffusion from the collector contact electrode for interconnecting the collector contact electrode (16, 41, 65) and the buried collector region (12, 32, 52, 52);
the emitter region (21, 45, 56) being isolated from the base contact electrode (15, 40, 64) and the collector contact electrode (16, 41,65) by a side wall insulating layer (17, 42, 63); and
said base region comprising an intrinsic base region formed by diffusion from a silicon layer (47) between the side walls.

2. A bipolar transistor according to claim 1, wherein the base region (20/23, 44/43, 54/55) is formed by the intrinsic base region (20, 44, 54) and a graft base region (23, 43, 55) interconnecting the intrinsic base region (20, 44, 54) and the base contact electrode (15,40. 64).

3. A bipolar transistor according to claim 1 or claim 2, wherein the isolation region (14, 34, 51) has been formed by selective oxidation and the opening (10, 37, 70, 80) is formed through the isolation region.

4. A bipolar transistor according to claim 3, wherein the opening (10, 37) is formed to an inclined boundary surface between the isolation region (14, 34) and the device forming region (13, 33).

5. A bipolar transistor according to claim 1 or claim 2, wherein the isolation region (51) is a trench-shaped insulation layer and the opening (70, 80) is formed at a side of the insulating layer towards the device forming region (53).

6. A bipolar transistor according to claim 5, wherein an insulating layer (81) is formed on a side wall of the opening (80) and the opening (80) is contacted only at the bottom (82) thereof by the buried collector region (52/83).

7. A process for manufacturing a bipolar transistor including:
a buried collector region (32) in a device forming region (13) surrounded by an isolation region (34) of a monocrystalline semiconductor body (31); and
a base region (44/43) and an emitter region (45) surrounded by the base region on a surface of the device forming region (33);
said processing comprising:
forming an opening (37) through the isolation region by etching off at least a portion of the isolation region (34);
forming a semiconductor layer (38) on the entire surface which extends over the isolation region and extends into the opening (37);
partially removing the semiconductor layer (38) to form a collector contact electrode (41) spaced from a base contact electrode (40), the collector contact electrode (41) extending through the opening (37); and
forming a collector contact region (46) contiguous to the buried collector region (32) by impurity diffusion from the collector contact electrode (41), the collector contact region (46) interconnecting the buried collector region (32) and the collector contact electrode (41);
forming a side wall insulating layer (42) where the semiconductor layer (38) was removed; and
forming an intrinsic base region (44) by diffusion from a silicon layer (47) between the side walls.

8. A process for manufacturing a bipolar transistor according to claim 7, the process additionally comprising:
forming a buried collector region (32) in a monocrystalline semiconductor substrate (31);
producing an epitaxial layer (33) on the monocrystalline semiconductor substrate (31);
forming a mask selectively on the epitaxial layer (33), which layer acts as the device forming region, and also forming the isolation region (34) surrounding the device forming region (33) by selective oxidation;
forming an insulating film (35) over the entire surface;
forming the opening (37) in a portion of the device forming region (33);
forming the semiconductor layer (38) on the entire surface which extends over the isolation region and extends into the opening (37);
introducing an impurity into the semiconductor layer (38) so that the layer has different conductivity types as between a first region thereof and a second region thereof which is spaced from the first region and extends through the opening (37);
partially removing the semiconductor layer (38) so that it is divided to form the base and collector contact electrodes (40, 41) corresponding to the first and second regions of different conductivity types and so that the device forming region (33) is exposed;
forming the side wall insulating layer (42) where the semiconductor layer (38) was removed; and
forming an emitter region (45) contiguous with a surface of the side wall insulating layer (42).

## Patentansprüche

1. Bipolartransistor mit
einem monokristallinen Halbleiterkörper (11,31,50), auf dessen einer Fläche ein Isolatorbereich (14,34,51) ausgebildet ist,
einem ein Bauteil bildenden Bereich (13, 33, 53), der von dem Isolatorbereich (14,34,51) umgeben ist,
einem vergrabenen Kollektorbereich (12,32,52,52), der in einem Abschnitt des ein Bauteil bildenden Bereichs (13,33,53) innerhalb des Halbleiterkörpers (11,31,50) gebildet ist,
einem Basisbereich (20/23,44/43,54/55) angrenzend an einen Abschnitt einer Fläche des ein Bauteil bildenden Bereichs (13,33,53),
einem Emitterbereich (21,45,56) angrenzend an einen Abschnitt der Fläche des ein Bauteil bildenden Bereichs (13,33,53) und umgeben von dem Basisbereich (20/23,44/43,54/55),
einer Basiskontaktelektrode (15,40,64), die sich von dem Isolatorbereich (14,34,51) bis über den ein Bauteil bildenden Bereich (13,33,53) erstreckt und mit dem Basisbereich (20/23,44/43,54/55) an der Fläche des ein Bauteil bildenden Bereichs (13,33,53) verbunden ist,
einer Kollektorkontaktelektrode (16,41,65), die von der Basiskontaktelektrode (15,40,64) räumlich entfernt ist und
einer Öffnung (10,37,70,80), die durch wenigstens einen Abschnitt des Isolatorbereichs (14,34,51) hindurch ausgebildet ist,
wobei die Kollektorkontaktelektrode (16,41,65) über dem Isolatorbereich (14,34,51) ausgebildet ist und sich durch die Öffnung (10,37,70,80) erstreckt,
**gekennzeichnet** durch
die Ausbildung der Kollektorkontaktelektrode (16,41,65) von einer Halbleiterschicht (38), die sich über dem Isolatorbereich (14,34,51) und ebenso durch die Öffnung (10,37,70,80) erstreckt,
einen Kollektorkontaktbereich (22,46,57,83), der an den vergrabenen Kollektorbereich (12,32,52,52) angrenzt und durch Störstellendiffusion von der Kollektorkontaktelektrode zur Verbindung der Kollektorkontaktelektrode (16,41,65) mit dem vergrabenen Kollektorbereich (12,32,52,52) gebildet ist,
die Isolierung des Emitterbereichs (21,45,56) von der Basiskontaktelektrode (15,40,64) und der Kollektorkontaktelektrode (16,41,65) durch eine isolierende Seitenwandschicht (17,42,63)
und dadurch, daß der Basisbereich einen intrinsischen Basisbereich aufweist, der durch Diffusion von einer Siliziumschicht (47) zwischen den Seitenwänden ausgebildet ist.

2. Bipolartransistor nach Anspruch 1, bei dem der Basisbereich (20/23,44/43,54/55) durch den intrinsischen Basisbereich (20,44,54) und einen aufgebrachten Basisbereich (23,43,55) gebildet ist, der den intrinsischen Basisbereich (20,44,54) mit der Basiskontaktelektrode (15,40,64) verbindet.

3. Bipolartransistor nach einem der vorhergehenden Ansprüche, bei dem der Isolatorbereich (14,34,51) durch selektive Oxidation und die Öffnung (10,37,70,80) durch den Isolatorbereich hindurch gebildet ist.

4. Bipolartransistor nach Anspruch 3, bei dem die Öffnung (10,37) eine geneigte Grenzfläche zwischen dem Isolatorbereich (14,34) und dem ein Bauteil bildenden Bereich (13,33) bildet.

5. Bipolartransistor nach Anspruch 1 oder 2, bei dem der Isolatorbereich (51) eine grabenförmige Isolationsschicht ist und die Öffnung (70,80) an einer Seite der Isolationsschicht in Richtung des ein Bauteil bildenden Bereichs (53) gebildet ist.

6. Bipolartransistor nach Anspruch 5, bei dem eine isolierende Schicht (81) an einer Seitenwand der Öffnung (80) gebildet ist und die Öffnung (80) nur an ihrem Boden (82) durch den vergrabenen Kollektorbereich (52/83) kontaktiert ist.

7. Herstellungsverfahren für einen Bipolartransistor mit
einem vergrabenen Kollektorbereich (32) in einem ein Bauteil bildenden Bereich (13), der von einem Isolatorbereich (34) eines monokristallinen Halbleiterkörpers (31) umgeben ist, und
einem Basisbereich (44/43) und einem Emitterbereich (45), der von dem Basisbereich auf einer Fläche des ein Bauteil bildenden Bereichs (33) umgeben ist, wobei das Verfahren die folgenden Schritte umfaßt:
Ausbilden einer Öffnung (37) durch den Isolatorbereich hindurch durch Abätzen wenigstens eines Abschnitts des Isolatorbereichs (34),
Ausbilden einer Halbleiterschicht (38) auf der gesamten Oberfläche, die sich über dem Isolatorbereich und in die Öffnung (37) hinein erstreckt,
teilweises Entfernen der Halbleiterschicht (38) zur Bildung einer Kollektorkontaktelektrode (41), die von einer Basiskontaktelektrode (40) räumlich entfernt ist, wobei sich die Kollektorkontaktelektrode (41) durch die Öffnung (37) hindurch erstreckt,
Ausbilden eines Kollektorkontaktbereichs (46), der dem vergrabenen Kollektorbereich (32) benachbart ist, durch Störstellendiffusion von der Kollektorkontaktelektrode (41), wobei der Kollektorkontaktbereich (46) den vergrabenen Kollektorbereich (32) mit der Kollektorkontaktelektrode (41) verbindet,
Ausbilden einer isolierenden Seitenwandschicht (42) an der Stelle, an der die Halbleiterschicht (38) entfernt wurde, und
Ausbilden eines intrinsischen Basisbereichs (44) durch Diffusion von einer Siliziumschicht (47) zwischen den Seitenwänden.

8. Herstellungsverfahren für einen Bipolartransistor gemäß Anspruch 7, wobei das Verfahren zusätzlich die folgenden Schritte aufweist:
Ausbilden eines vergrabenen Kollektorbereichs (32) in einem monokristallinen Halbleitersubstrat (31),
Herstellen einer Epitaxieschicht (33) auf dem monokristallinen Halbleitersubstrat (31),
selektives Ausbilden einer Maske auf der Epitaxieschicht (33), wobei die Schicht als der ein Bauteil bildende Bereich dient und ebenso Ausbilden des Isolatorbereichs (34), der den ein Bauteil bildenden Bereich (33) umgibt, durch selektive Oxidation,
Ausbilden eines Isolatorfilms (35) über der gesamten Oberfläche,
Ausbilden der Öffnung (37) in einem Abschnitt des ein Bauteil bildenden Bereichs (33), Ausbilden der Halbleiterschicht (38) auf der gesamten Fläche, die sich über dem Isolatorbereich und in die Öffnung (37) hinein erstreckt,
Einbringen von Störstellen in die Halbleiterschicht (38), derart, daß die Schicht verschiedene Leitungstypen aufweist in einem ersten Bereich von ihr und in einem zweiten Bereich von ihr, der von dem ersten Bereich räumlich entfernt liegt und sich durch die Öffnung (37) erstreckt,
teilweises Entfernen der Halbleiterschicht (38), derart, daß sie aufgeteilt ist zur Bildung der Basis und Kollektorkontaktelektroden (40,41) entsprechend des ersten und zweiten Bereichs mit verschiedenen Leitungstypen, und so, daß der ein Bauteil bildender Bereich (33) freigelegt ist,
Ausbilden der isolierenden Seitenwandschicht (42) an der Stelle, an der die Halbleiterschicht (38) entfernt wurde, und
Ausbilden eines Emitterbereichs (45) benachbart einer Fläche der isolierenden Seitenwandschicht (42).

## Revendications

1. Transistor bipolaire comportant :
un corps semiconducteur monocristallin (11, 31, 50) sur une surface duquel est formée une région d'isolation (14, 34, 51) ;
une région de formation du dispositif (13, 33, 53) entourée par la région d'isolation (14, 34, 51) ;
une région de collecteur enterrée (12, 32, 52, 52) formée dans une partie de la région de formation du dispositif (13, 33, 53) à l'intérieur du corps semiconducteur (11, 31, 50) ;
une région de base (20/23, 44/43, 54/55) adjacente à une partie d'une surface de la région de formation du dispositif (13, 33, 53) ;
une région d'émetteur (21, 45, 56) adjacente à une partie de la surface de la région de formation du dispositif (13, 33, 53) et entourée par la région de base (20/23, 44/43, 54/55) ;
une électrode de contact de base (15, 40, 64) s'étendant depuis la région d'isolation (14, 34, 51) jusqu'au-dessus de la région de formation du dispositif (13, 33, 53) et reliée à la région de base (20/23, 44/43, 54/55) sur la surface de formation du dispositif (13, 33, 53);
une électrode de contact de collecteur (16, 41, 65) espacée de l'électrode de contact de base (15, 40, 64) ; et
une ouverture (10, 37, 70, 80) formée à travers au moins une partie de la région d'isolation (14, 34, 51) ;
l'électrode de contact de collecteur (16, 41, 65) étant formée au-dessus de la région d'isolation (14, 34, 51) et s'étendant à travers l'ouverture (10, 37, 70, 80), caractérisé en ce que :
l'électrode de contact de collecteur (16, 41, 65) est formée à partir d'une couche semiconductrice (38) s'étendant au-dessus de la région d'isolation (14, 34, 51) et s'étendant également à travers l'ouverture (10, 37, 70, 80) ;
une région de contact de collecteur (22, 46, 57, 83)est adjacente à la région de collecteur enterrée (12, 32, 52, 52) formée par diffusion d'impuretés à partir de l'électrode de contact de collecteur pour relier l'électrode de contact de collecteur (16, 41, 65) et la région de collecteur enterrée (12, 32, 52, 52) ;
la région d'émetteur (21, 45, 56) est isolée de l'électrode de contact de base (15, 40, 64) et de l'électrode de contact de collecteur (16, 41, 65) par une couche isolante à paroi latérale (17, 42, 63) ; et
ladite région de base comporte une région de base intrinsèque formée par diffusion depuis une couche de silicium (47) entre les parois latérales.

2. Transistor bipolaire selon la revendication 1, dans lequel la région de base (20/23, 44/43, 54/55) est formée par la région de base intrinsèque (20, 44, 54) et la région de base dopée (23, 43, 55) reliant la région de base intrinsèque (20, 44, 54) et l'électrode de contact de base (15, 40, 64).

3. Transistor bipolaire selon la revendication 1 ou la revendication 2, dans lequel la région d'isolation (14, 34, 51) a été formée par oxydation sélective et l'ouverture (10, 37, 70, 80) est formée à travers la région d'isolation.

4. Transistor bipolaire selon la revendication 3, dans lequel l'ouverture (10, 37) est formée dans une surface limite inclinée entre la région d'isolation (14, 34) et la région de formation du dispositif (13, 33).

5. Transistor bipolaire selon la revendication 1 ou la revendication 2, dans lequel la région d'isolation (51) est une couche d'isolation sous forme de tranchée et l'ouverture (70, 80) est formée sur un côté de la couche isolante vers la région de formation du dispositif (53).

6. Transistor bipolaire selon la revendication 5, dans lequel une couche isolante (81) est formée sur une paroi latérale de l'ouverture (80) et l'ouverture (80) est au contact seulement à la base (82) de celle-ci par la région de collecteur enterrée (52/83).

7. Procédé de fabrication d'un transistor bipolaire comprenant :
une région de collecteur enterrée (32) dans une région de formation du dispositif (13) entourée par une région d'isolation (34) d'un corps semiconducteur monocristallin (31) ; et
une région de base (44/43) et une région d'émetteur (45) entourée par la région de base sur une surface de la région de formation du dispositif (33) ;
ledit procédé comportant :
la formation d'une ouverture (37) à travers la région d'isolation par gravure d'au moins une partie de la région d'isolation (34) ;
la formation d'une couche semiconductrice (38) sur toute la surface s'étendant au-dessus de la région d'isolation et s'étendant dans l'ouverture (37) ;
l'élimination partielle de la couche semiconductrice (38) pour former une électrode de contact de collecteur (41) espacée de l'électrode de contact de base (40), l'électrode de contact de collecteur (41) s'étendant à travers l'ouverture (37) ; et
la formation d'une région de contact de collecteur (46) adjacente à la région de collecteur enterrée (32) par diffusion d'impuretés depuis l'électrode de contact de collecteur (41), la région de contact de collecteur (46) reliant la région de collecteur enterrée (32) et l'électrode de contact de collecteur (41) ;
la formation d'une couche isolante à paroi latérale (42) où la couche semiconductrice (38) a été éliminée; et
la formation d'une région de base intrinsèque (44) par diffusion à partir d'une couche de silicium (47) entre les parois latérales.

8. Procédé de fabrication d'un transistor bipolaire selon la revendication 7, comportant en outre :
la formation d'une région de collecteur enterrée (32) dans un substrat semiconducteur monocristallin (31);
le dépôt d'une couche épitaxiale (33) sur le substrat semiconducteur monocristallin (31) ;
la formation sélective d'un masque sur la couche épitaxiale (33), couche jouant le rôle de région de formation du dispositif, et également la formation de la région d'isolation (34) entourant la région de formation du dispositif (33) par oxydation sélective ;
la formation d'une pellicule isolante (35) sur la surface toute entière ;
la formation de l'ouverture (37) dans une partie de la région de formation du dispositif (33) ;
la formation de la couche semiconductrice (33) sur toute la surface qui s'étend au-dessus de la région d'isolation et s'étend dans l'ouverture (37) ;
l'introduction d'une impureté dans la couche semiconductrice (38), de sorte que la couche présente des types de conductivité différents tels qu'entre une première région de celle-ci et une seconde région de celle-ci qui est espacée de la première région et s'étend à travers l'ouverture (37) ;
l'élimination partielle de la couche semiconductrice (38) de sorte qu'elle est divisée pour former des électrodes de contact de base et de collecteur (40, 41) correspondant aux première et seconde régions de types de conductivité différents et de sorte que la région de formation du dispositif (33) est mise à nu ;
la formation de la couche isolante à paroi latérale (42) où la couche semiconductrice (38) a été éliminée; et
la formation d'une région d'émetteur (45) adjacente à une surface de la couche isolante à paroi latérale (42).
